# EUROPEAN PATENT APPLICATION

(11) **EP 2 375 865 A1**
(43) Date of publication of application: **12.10.2011**
(21) Application number: 09829204.8
(22) Date of filing: 26.11.2009
(51) Int. Cl.: H05B 33/22, H01L 51/50, H05B 33/10, H05B 33/12

(54) **LIGHT EMISSION DEVICE AND METHOD FOR MANUFACTURING SAME**

(30) Priority: 28.11.2008 JP 2008303864
(71) Applicant: Sumitomo Chemical Company, Limited, Tokyo 104-8260 (JP)
(72) Inventor: KURIHARA, Takashi, Tsukuba-shi Ibaraki 305-0045 (JP); NISHIOKA, Yukiya, Nara-shi Nara 631-0034 (JP); KAJITANI, Masaru, Niihama-shi Ehime 792-0025 (JP); FUJISAWA, Takuji, Niihama-shi Ehime 792-0025 (JP); AKATSU, Mitsutoshi, Niihama-shi Ehime 792-0009 (JP); AMAMIYA, Satoshi, Niihama-shi Ehime 792-0025 (JP)
(74) Representative: Jackson, Martin Peter
(86) International application number: PCT/JP2009/070277
(87) International publication number: WO 2010/061966

(57) **Abstract**

A light-emitting device comprises: a substrate; a plurality of organic electroluminescent elements provided on the substrate; and a partition defining pixel areas in each of which one of the organic EL elements is provided. The partition comprises an insulating film provided with openings each hollowly formed in an area corresponding to one of the pixel areas and a partition body provided on an opposite side of the insulating film with respect to the substrate. Each of the organic EL elements comprises a pair of electrodes and a light-emitting portion that is interposed between the electrodes and that is arranged in an area surrounded by the insulating film. The thickness of the insulating film is smaller than the thickness of the light-emitting portion.

## Description

### TECHNICAL FIELD

The present invention relates to a light-emitting device and a method for manufacturing thereof.

### BACKGROUND ART

Light-emitting devices (such as display devices and illumination devices) are attracting attention in which organic electroluminescent elements (hereinafter, also referred to as "organic EL elements") are used as light-emitting elements. For example, a plurality of organic EL elements each functioning as a pixel are arranged on the substrate in a display device. The organic EL elements are electrically insulated from each other by a partition so as to be driven independently from each other. This partition is formed, for example, in a grid, and each of the organic EL elements is arranged in an area surrounded by the partition. Accordingly, the organic EL elements are arranged in a matrix.

An organic layer (such as a light-emitting layer) constituting the organic EL element can be formed by a coating method. Specifically, an ink containing an organic material and a solvent is selectively supplied into an area surrounded by the partition and is then dried to form an organic layer in the area surrounded by the partition.

The organic material constituting the organic layer does not necessarily have high solubility in the solvent, and the concentration of the organic material in the ink is generally about 1 percent by weight. Therefore, a large amount of ink is to be supplied as compared with the volume of the organic layer to be formed. However, the partition also functions as a so-called container for ink and thus contains the ink supplied into the area surrounded by the partition without overflowing. The ink is dried as it is to be formed into a film that serves as an organic layer.

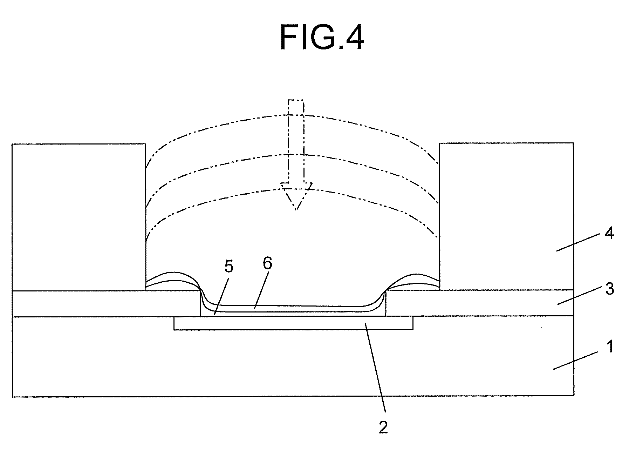

Fig. 4 is an end elevation view of a conventional substrate used for forming an organic EL element. An anode 2 is provided on a substrate 1, an insulating film 3 surrounding the anode 2 is provided thereon, and a partition body 4 is provided on the insulating film 3. The partition also functions as a container containing ink and therefore is generally made of a material having lyophobicity to ink in order to prevent the supplied ink from being overflowed and flowing into adjacent pixels. However, when the partition is made only from the material having lyophobicity, the supplied ink is dried while being repelled by the partition. As a result, the film thickness of the organic layer at the outer edge becomes smaller when the ink is formed into a film. Thus, to avoid non-uniformity of the film thickness caused at the edge of pixel areas, the insulating film 3 having lyophilicity is provided between the partition body 4 and the substrate 1 (for example, see JP 2005-174906 A).

### DISCLOSURE OF INVENTION

As indicated by an arrow in Fig. 4, the solvent is vaporized to gradually dry the ink supplied into the partition, and the liquid level moves toward the substrate 1. In this process, the ink is dried while being attracted to the insulating film 3 because the insulating film 3 has lyophilicity. As a result, unequal distribution occurs in the film thickness of the organic layer near the edge of the insulating film 3. Fig. 4 illustrates a state where two organic layers 5 and 6 are formed by a coating method.

As illustrated in Fig. 4, the film thickness of the organic layers 5 and 6 near the edge of the insulating film 3 differs from that at the center of the pixel area due to the presence of the insulating film 3. The non-uniformity of the film thickness causes light emission failure. The organic EL element is formed by further providing a cathode on the two organic layers 5 and 6. For example, when the organic layer (lower layer) 5 close to the anode 2 has high conductivity, leak current may occur near the edge of the insulating film 3 while the organic EL element is made to emit light. This is because the organic layer (upper layer) 6 close to the cathode has a thin film thickness near the edge of the insulating film 3.

An object of the present invention is to provide a light-emitting device comprising an organic EL element capable of comprising an organic layer having a uniform film thickness in a pixel areas, and a method for manufacturing thereof.

The present invention relates to a light-emitting device comprising:
a substrate;
a plurality of organic electroluminescent elements provided on the substrate; and
a partition defining pixel areas in each of which one of the organic electroluminescent elements is provided, wherein the partition comprises an insulating film provided with openings each hollowly formed in an area corresponding to one of the pixel areas and a partition body provided on an opposite side of the insulating film with respect to the substrate,
each of the organic electroluminescent elements comprises a pair of electrodes and a light-emitting portion that is interposed between the electrodes and that is arranged in an area surrounded by the partition, and
the thickness of the insulating film is smaller than the thickness of the light-emitting portion.

The present invention relates to a light-emitting device, wherein the thickness of the insulating film is less than 50 nanometers.

The present invention relates to a light-emitting device, wherein an opening defined by a side face of the insulating film facing each of the openings has a shape that is forward-tapered in a direction directing to the substrate.

The present invention relates to a light-emitting device, wherein when viewed from one side of the thickness direction of the substrate, the distance between a side face of the insulating film facing the pixel areas and a side face of the partition body facing the pixel areas is 1 micrometer or more.

The present invention relates to a light-emitting device, wherein the light-emitting portion comprises an organic layer formed by a coating method using an ink containing an organic material.

The present invention relates to a light-emitting device, wherein the insulating film exhibits lyophilicity to the ink more than the partition body does.

The present invention relates to a light-emitting device, wherein the light-emitting portion is formed by stacking a plurality of layers comprising a hole injection layer provided closest to the substrate.

The present invention relates to a method for manufacturing a light-emitting device comprising a plurality of organic electroluminescent elements each comprising a pair of electrodes and a light-emitting portion interposed between the pair of electrodes, the method comprising:
a step of forming, on a substrate, a partition defining pixel areas in each of which one of the organic electroluminescent elements is provided;
a step of forming the electrodes; and
a step of forming the light-emitting portion in each of the pixel areas, wherein
in the step of the forming the partition, an insulating film is formed that has a thickness smaller than the thickness of the light-emitting portion and that is provided with openings each hollowly formed in an area corresponding to one of the pixel areas, and a partition body is formed on the insulating film, and
in the step of forming the light-emitting portion, an ink containing an organic material is supplied into the pixel areas, and the ink thus supplied is dried to form an organic layer.

The present invention relates to a method for manufacturing a light-emitting device, wherein in hollowly forming openings in the insulating film, openings each having a shape that is forward-tapered in a direction directing to the substrate are hollowly formed in the insulating film by dry etching.

The present invention relates to a method for manufacturing a light-emitting device, wherein in forming the partition body, the partition body is formed using an organic substance and then a plasma treatment performed in a fluorine-containing gas atmosphere.

### BRIEF DESCRIPTION OF DRAWINGS

Fig. 1 is a sectional schematic of a light-emitting device 11 of an embodiment of the present invention.
Fig 2 is a plane schematic of the light-emitting device 11.
Fig. 3 is a schematic illustrating a process of forming a tapered insulating film 17.
Fig. 4 is an end elevation view of a conventional substrate used for forming an organic EL element.

### EXPLANATIONS OF LETTERS OR NUMERALS

- 1: Substrate
- 2: Anode
- 3: Insulating film
- 4: Partition body
- 5: Organic layer (lower layer)
- 6: Organic layer (upper layer)
- 11: Light-emitting device
- 12: Organic EL element
- 13: Substrate
- 14: Pixel area
- 15: Partition
- 16: Opening
- 17: Insulating film
- 18: Partition body
- 21: Anode
- 22: Cathode
- 23: Light-emitting portion
- 24: Light-emitting layer
- 25: Hole injection layer
- 31: Thin film having insulating properties
- 32: Photoresist
- 33: Protective film

### BEST MODE(S) FOR CARRYING OUT THE INVENTION

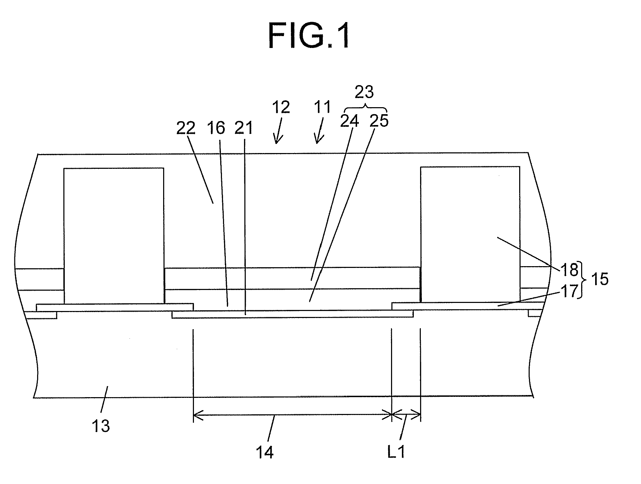

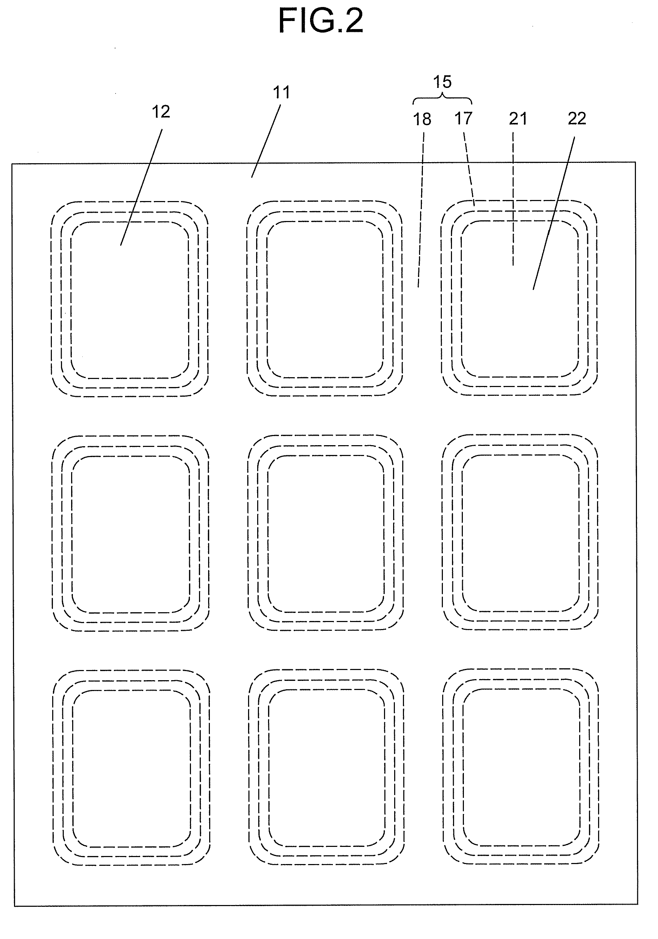

Fig. 1 is a sectional schematic of a light-emitting device 11 of the present embodiment, and Fig. 2 is a plane schematic of the light-emitting device 11. A number of organic EL elements are provided in a matrix in a typical light-emitting device used as a display device. In the present embodiment, the light-emitting device 11 is described in which nine organic EL elements 12 are arrayed in three rows and three columns for the sake of clarity. Fig. 1 illustrates only an area in which one of the organic EL elements 12 is formed.

The light-emitting device 11 of the present embodiment comprises a substrate 13, a plurality of the organic EL elements 12 provided on the substrate 13, and a partition 15 defining each pixel area 14 in which each of the organic EL elements 12 is provided.

The partition 15 comprises an insulating film 17 provided with openings 16 each hollowly formed in an area corresponding to one of the pixel areas 14, and a partition body 18 provided on an opposite side of the insulating film 17 with respect to the substrate 13. Each of the organic EL elements 12 comprises a pair of electrodes 21 and 22 and a light-emitting portion 23 that is interposed between the electrodes 21 and 22 and that is arranged in the area (pixel area 14) surrounded by the partition 15. The film thickness of the light-emitting portion is generally 10 nanometers to 150 nanometers.

The present embodiment describes the light-emitting device 11 functioning as an active matrix type display device, but the light-emitting device 11 may be either the active matrix type display device or a passive matrix type display device.

When the light-emitting device 11 comprises mxn pieces (symbols "m" and "n" are each a natural number. m=3 and n=3 in the present embodiment) of pixels, mxn pieces of organic EL elements each functioning as a pixel are arranged in a matrix of m rows and n columns.

The partition 15 is formed on the substrate 13 in a grid, and each of the organic EL elements 12 is provided in an area defined by the partition 15 to arrange the organic EL elements 12 in a matrix.

A thin film transistor (TFT) substrate on which a circuit for an active matrix type display device is formed can be used for the substrate 13. Each organic EL element 12 comprises the anode 21 with these anodes 21 separated from each other. The anodes 21 are separately arranged on the substrate 13 in a matrix of m rows and n columns and are electrically connected to the circuit formed on the substrate 13. In the present embodiment, one of the pair of electrodes 21 and 22 that is provided close to the substrate 13 is designated as the anode 21, and the other electrode is designated as the cathode 22. An organic EL element in which one of the electrodes that is provided close to the substrate 13 is designated as a cathode, and the other electrode is designated as an anode may also be provided on the substrate.

At least the outer edge of the anode 21 is covered by the edge of the insulting film 17 when viewed from one side of the thickness direction of the substrate 13. The outer edge of the anode 21 may also be overlapped with a portion of the partition body 18 when viewed from one side of the thickness direction of the substrate 13.

The insulating film 17 is like a membrane, has openings each hollowly formed through the area corresponding to one of the pixel areas 14, and is formed in a grid. Even when a light-emitting layer 24 described later is provided on the insulating film 17, the light-emitting layer 24 on the insulating film 17 does not emit light because the anode 21 is electrically insulated from the cathode 22 by the insulating film 17. In other words, when viewed from one side of the thickness direction of the substrate 13, the light-emitting portion 23 provided at the opening 16 formed in the insulating film 17 alone emits light, and thus, the area surrounded by the partition 15 and particularly by the insulating film 17 corresponds to the light-emittable pixel area 14.

The partition body 18 is provided so as to come in contact with the insulating film 17 in the present embodiment. A certain layer may also be interposed between the insulating film 17 and the partition body 18. The partition body 18 is formed on the insulating film 17 at a distant from the pixel area 14. In other words, the partition body 18 is formed inside of the insulating film 17 in a grid when viewed from one side of the thickness direction of the substrate 13.

The light-emitting portion 23 is provided in each area defined by the partition body 18. The light-emitting portion 23 is formed over the opening 16 hollowly formed in the insulating film 17 and is provided so as to come in contact with the anode 21 exposing from the opening 16. The thickness of the insulating film 17 is smaller than the thickness of the light-emitting portion 23. Accordingly, the light-emitting portion 23 is formed not only in the opening 16 hollowly formed in the insulating film 17 but also onto the insulating film 17 beyond the opening 16.

The cathode 22 is formed over the whole surface of the substrate 13 so as to cover the light-emitting portion 23 and the partition body 18 from one side of the thickness direction of the substrate 13. In other words, the cathodes 22 of the organic EL elements 12 are electrically connected to each other and thus function as a single common electrode.

A method for manufacturing the light-emitting device 11 is described below.

A TFT substrate is prepared. Commercial TFT substrates are available, and generally, electrodes are formed on such TFT substrates. In the bottom emission type organic EL element 12 from which light is extracted after passing through the anode 21 and the substrate 13, the anode 21 is an electrode having light transparency. A thin film of metallic oxides, metallic sulphides, metals, or other compounds, which have high electric conductivity is applicable to the anode 21, and the anode 21 with high light transparency is suitably used. Specifically, a thin film made of, for example, indium oxide, zinc oxide, tin oxide, indium tin oxide (ITO), indium zinc oxide (IZO), gold, platinum, silver, and copper is used, and among them, a thin film made of ITO, IZO, and tin oxide is suitably used. Examples of a method for forming the anode 21 include a vacuum deposition method, a sputtering method, an ion plating method, and a plating method. A conductive film is formed by such methods and then is formed in a predetermined pattern by a photolithography method. A transparent conductive film of an organic substance such as polyaniline or derivatives thereof and polythiophene or derivatives thereof may also be used for the anode.

The film thickness of the anode can be appropriately selected in consideration of light transparency and electric conductivity and is, for example, 10 nanometers to 10 micrometers, preferably, 20 nanometers to 1 micrometer, and more preferably, 50 nanometers to 500 nanometers.

Subsequently, the insulating film 17 is formed. The insulating film 17 preferably exhibits lyophilicity to ink more than those of the partition body 18 and is preferably made of inorganic substances so as not to be hydrophobized at a step of hydrophobizing the partition body 18. The insulating film 17 is made of SiN, SiO₂, or other compounds and is preferably made of SiN.

The insulating film 17 is formed by, a sputtering method, chemical vapor deposition (CVD), mask vapor deposition, a spin coating method, or other methods. For example, a thin film having insulating properties is formed on the whole surface by CVD, then, a photoresist is applied thereon, and a predetermined area is irradiated with light and is developed to form a protective film of a photoresist layer. Subsequently, the openings 16 each hollowly formed in an area corresponding to one of the pixel areas 14 of the thin film having insulating properties by dry etching or wet etching, and thus, the insulating film 17 can be formed.

The thickness of the insulating film 17 is smaller than the thickness of the light-emitting portion 23 and is preferably, less than 100 nanometers, more preferably, less than 50 nanometers, further preferably, less than 30 nanometers, and particularly preferably less than 10 nanometers. The lower limit of the thickness of the insulating film 17 is appropriately set to the thickness with which the film can ensure electric insulating properties depending on the member constituting the insulating film 17, and is generally 5 nanometers.

The width of the insulating film 17, that is, the spacing between the pixel areas 14 neighboring in the row direction or the column direction is appropriately set depending on the resolution and is generally about 10 micrometers to 50 micrometers.

Subsequently, the partition body 18 is formed. The partition body 18 preferably exhibits lyophobicity to ink and preferably includes organic substances that are hydrophobized by a simple method such as a plasma treatment performed in a fluorine-containing gas atmosphere. The partition body 18 is formed using for example, a positive or negative photosensitive material (photoresist) of acrylic resins, novolac resins, or polyimide resins, which is preferable because patterning can be performed readily. Specifically, a photoresist is applied onto the whole surface of the substrate and is subjected to a pre-bake treatment. A predetermined area is irradiated with light through a predetermined mask to be developed and is further subjected to a post-bake treatment to produce the partition body 18 patterned in a predetermined shape. Examples of the method of coating a photoresist include a method using a spin coater, a slit coater, or the like.

The partition body 18 is then subjected to a hydrophobizing treatment. For example, when the partition body 18 is formed from organic substances, the surface thereof can be hydrophobized by performing a plasma treatment in a fluorine-containing gas atmosphere. Specifically, the surface can be hydrophobized by performing a plasma treatment in a CF₄ gas atmosphere. The insulating film 17 made of inorganic substances is not hydrophobized by this plasma treatment and thus maintains its lyophilicity. In such a manner, the insulating film 17 is made of inorganic substances, the partition body 18 is made of organic substances, and then they are subjected to a plasma treatment in a fluorine-containing gas atmosphere. Accordingly, the partition body 18 having lyophobicity and the insulating film 17 having lyophilicity can be simply separately formed.

The thickness of the partition body 18 is set to the thickness with which ink is retainable while the light-emitting portion 23 is formed by a coating method and is generally, about 0.5 micrometer to 10 micrometers, and preferably, 1 micrometer to 3 micrometers.

The width of the partition body 18 is smaller than the width of the insulating film 17 and is about 10 micrometers to 50 micrometers.

Subsequently, the light-emitting portion 23 is formed. The light-emitting portion 23 preferably includes an organic layer formed by a coating method using ink containing organic materials.

The light-emitting portion 23 is preferably formed by stacking a plurality of layers including a hole injection layer 25 that is provided closest to the substrate. In the present embodiment, the light-emitting portion 23 is formed by stacking two organic layers of the hole injection layer 25 and the light-emitting layer 24. The hole injection layer 25 is provided so as to come in contact with the anode 21, the light-emitting layer 24 is provided so as to come in contact with the hole injection layer 25, and then the cathode 22 is provided so as to come in contact with the light-emitting layer 24.

The hole injection layer 25 is formed by a coating method using an ink containing an organic material for forming the hole injection layer 25 described later and a solvent dissolving the material. The coating method is not particularly limited so long as the ink can be selectively supplied into the area defined by the partition 15, and examples thereof include an ink-jet printing method and a flexo printing method. For example, the ink can be selectively dropped in a predetermined area by an ink-jet printing apparatus, and thus, the ink can be selectively supplied into the area defined by the partition 15. The hole injection layer 25 can be formed by drying the ink at the normal temperature or under heating application.

The light-emitting layer 24 is formed by a coating method using an ink containing an organic material for forming the light-emitting layer 24 described later and a solvent dissolving the material and can be formed in a manner similar to that of the hole injection layer 25.

The cathode 22 is preferably formed using a material that has a small work function, facilitates electron injection into the light-emitting layer, and has high electric conductivity. In the organic EL element 12 in which light is extracted from the anode, a material having high reflectance of visible light is preferred as the material for the cathode 22 because the cathode 22 reflects the light output from the light-emitting layer 24 to the anode 21. For example, alkali metals, alkaline-earth metals, transition metals, and Group III-B metals may be used for the cathode 22. Examples of the material for the cathode include: metals such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium; alloys of two or more types of the metals; alloys of one or more types of the metals and one or more types of gold, silver, platinum, copper, manganese, titanium, cobalt, nickel, tungsten, and tin; and graphite or graphite interlayer compounds. Examples of the alloys include magnesium-silver alloys, magnesium-indium alloys, magnesium-aluminum alloys, indium-silver alloys, lithium-aluminum alloys, lithium-magnesium alloys, lithium-indium alloys, and calcium-aluminum alloys. For the cathode, a transparent conductive electrode made of a conductive metal oxide, a conductive organic substance, or other substances may be used. Specific examples of the conductive metal oxide include indium oxide, zinc oxide, tin oxide, ITO, and IZO. Specific examples of the conductive organic substance may include polyaniline or derivatives thereof and polythiophene or derivatives thereof. The cathode may be a layered body in which two or more layers are stacked.

The film thickness of the cathode 22 is appropriately set in consideration of electric conductivity and durability and is for example, about 10 nanometers to 5 micrometers. In the present embodiment, the cathode 22 is formed to be a thick film so as to function as a protective member for blocking the light-emitting portion 23 from the external environment. Examples of the method for forming the cathode 22 include a vacuum deposition method, a sputtering method, and a lamination method by which a metal thin film is thermocompression bonded.

In the light-emitting device 11 of the present embodiment described above, the thickness of the insulating film 17 is formed to be smaller than the thickness of the light-emitting portion 23. In a conventional light-emitting device illustrated in Fig. 4, an insulating film 3 has a large film thickness. When such insulating film 3 is used, organic layers 5 and 6 have non-uniform film thicknesses due to the insulating film 3. Thus, organic layers having uniform film thicknesses cannot be formed in the pixel area. Display devices using organic EL elements have been developed by using technique most of which is diverted from technique for liquid crystal display devices. The technique used for liquid crystal display devices is not changed on purpose because liquid crystal display devices are widely available on the market, and the element technology has been established. Therefore, the film thickness of the insulating film 3 or the like takes over that of liquid crystal display devices. Accordingly, the film thickness of the insulating film 3 of the conventional light-emitting device illustrated in Fig. 4 is about 100 nanometers to 500 nanometers. However, slimness is one of the features of organic EL elements. Therefore, the insulating films of organic EL elements become thicker than the light-emitting portion when the insulating films used in liquid crystal display devices are utilized. As a result, the insulating films that are not problematic in the technique of liquid crystal display devices significantly adversely affect the formation of such organic layers. In the present embodiment, the insulating film 17 smaller than the light-emitting portion 23 is formed to enable the influence by the insulating film 17 to be small while organic layers such as the hole injection layer 25 and the light-emitting layer 24 are formed by a coating method. Consequently, organic layers having uniform film thickness can be formed. Particularly, each organic layer constituting the light-emitting portion 23 preferably has a thickness larger than that of the insulating film 17. For example, in the conventional art, ink is dried while being attracted to the insulating film 3 having lyophilicity, and therefore, the organic layer 5 near the edge of the insulating film 3 (see Fig. 4) is significantly influenced by the insulating film 3. In the present embodiment, however, each organic layer is thicker than the insulating film 17, and thus, the side face of the insulating film 17 hardly affects the formation of the organic layer in the first place, therefore enabling the formation of organic layers having uniform film thickness. Accordingly, the organic EL element 12 in which light emission failure is suppressed can be obtained, and thus, the light-emitting device 11 with high performance can be created. Particularly, when the layer closest to the substrate out of the layers constituting the light-emitting portion 23 is the hole injection layer 16 having low electric resistance, the possibility of the occurrence of leak current increases during light emission due to the element structure. This is because when the film thickness of the layer is non-uniform near the edge of the insulating film 17 as described in the conventional art illustrated in Fig. 4, the distance between the hole injection layer 16 and the cathode 22 may become small, or in some cases, the hole injection layer 16 may come in contact with the cathode 22. However, in the present embodiment, even when each organic layer is formed by a coating method, organic layers having uniform film thickness can be formed because each organic layer is thicker than the insulating film 17. Accordingly, the organic EL element 12 in which leak current or the like is suppressed can be obtained, and thus, the light-emitting device 11 with high performance can be created.

The thickness of such insulating film 17 is preferably less than 100 nanometers. The influence by the insulating film 17 during the formation of the light-emitting portion 23 can be reduced by forming the insulating film 17 having such thickness, and thus, organic layers having uniform film thickness can be obtained.

Moreover, the insulating film 17 is preferably formed so that the opening 16 defined by the side face of the insulating film 17 facing the openings 16 each have a shape that is forward-tapered in a direction directing to the substrate. The edge of the insulating film 17 becomes smooth by forming such tapered insulating film 17. Therefore, the influence by the insulating film 17 can further be reduced while the light-emitting portion 23 is formed at an uneven portion formed with the edge of the insulating film 17, and thus, organic layers having further uniform film thickness can be obtained.

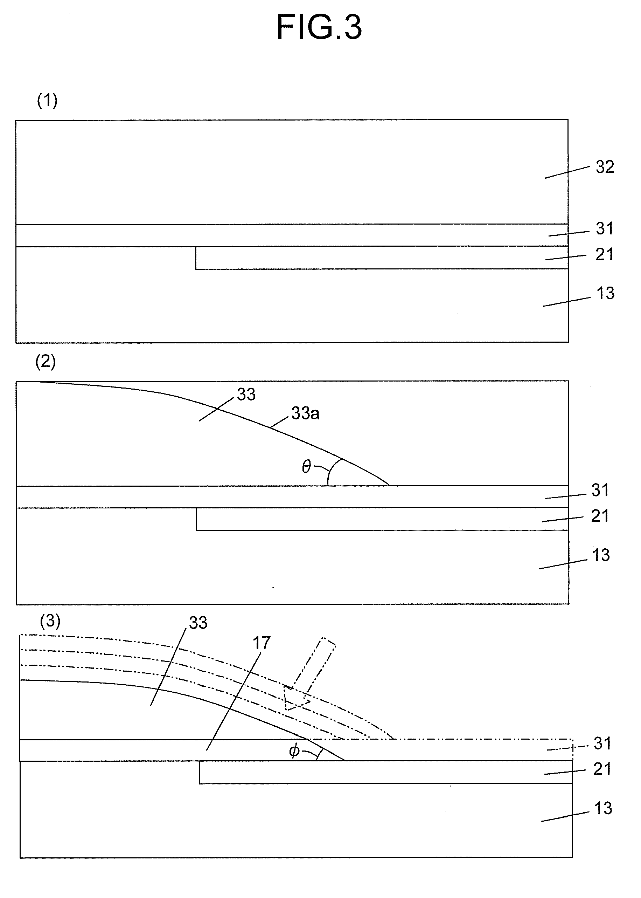

The tapered insulating film 17 can be formed by, for example, dry etching. Fig. 3 is a schematic illustrating a process for forming the tapered insulating film 17. As described above, a thin film 31 that has insulating properties and that is made of SiN or other compounds is formed on the whole surface by CVD or the like. By CVD, the thin film 31 of about 10 nanometers to 20 nanometers can be formed, and the thin film 31 having a film thickness of 10 nanometers to 20 nanometers or more can be formed as appropriate. A photoresist 32 is applied onto the whole surface of the thin film 31 having insulating properties (see Fig. 3(1)) and then is subjected to processes such as pre-bake, light exposure, development, and post-bake to remove a portion that is of the thin film 31 having insulating properties and that is formed on the pixel area. A side face 33a of a protective film 33 formed using the photoresist 32 is not vertical to the surface of the thin film 31 having insulating properties. As illustrated in Fig. 3(2), the side face 33a is inclined toward the surface of the thin film 31 having insulating properties, and an inclined angle θ thereof is about 10 degrees to 60 degrees. The dry etching is generally anisotropic etching, and therefore, for example, when plasma etching is performed while CF₄ gas is introduced, a through-hole vertical to the substrate 13 is formed in the thin film 31 having insulating properties. In other words, the side face of the thin film 31 surrounding the through-hole becomes vertical to the substrate 13. However, when plasma etching is performed in an atmosphere in which O₂ is introduced in addition to CF₄, not only the thin film 31 having insulating properties but also the protective film 33 are etched during the etching as illustrated in Fig. 3(3). Accordingly, the thin film 31 having insulating properties is etched while the area protected by the protective film 33 is moved as indicated by an arrow. As a result, the tapered insulating film 17 is formed. An angle ϕ that the side face of the insulating film 17 facing the pixel area 14 forms with the surface of the anode 21 is preferably 10 degrees to 60 degrees. The angle ϕ can be adjusted by appropriately setting materials for the protective film 33, the inclined angle θ of the protective film 33, and the amount of flow of CF₄ and O₂ gas introduced during etching. Particularly, the angle ϕ can be adjusted by adjusting the amount of flow of O₂ gas introduced during etching, and specifically, the angle ϕ tends to be small in accordance with the increase in the amount of flow of O₂ gas.

When viewed from one side of the thickness direction of the substrate 13, a distance L1 between the side face of the insulating film 17 facing the pixel area 14 and the side of the partition body 18 facing the pixel area 14 is preferably 1 micrometer or more (see Fig. 1). The partition body 18 is generally formed so that the surface thereof has lyophobicity to ink in order to fulfill the ink containing function, and therefore, supplied ink dries while being repelled by the partition body 18. This leads to non-uniform film thickness, for example, the film thickness of the organic layer becomes thin near the partition body 18. One of the reasons for providing the insulating film 17 in addition to the partition body 18 is to inhibit the reduction of the light-emitting properties of the element that arises from the non-uniform film thickness near the partition body 18. However, when a portion of the insulating film 17 that protrudes from the partition body 18 is small, the influence by the partition body 18 on the film thickness distribution of the organic layer becomes apparent in the pixel area 14. Thus, the influence exerted by the partition body 18 on the film thickness distribution of the organic layer in the pixel area 14 can be reduced by setting the distance L1 to 1 micrometer or more. Consequently, an organic layer having uniform film thickness can be formed in the pixel area 14. The distance L1 is appropriately set depending on the design of the resolution or the like, however, the aperture ratio decreases when the distance L1 is excessively large. Therefore, the upper limit of the distance L1 is generally about 5 micrometers.

The organic EL element in the light-emitting device 11 of the present embodiment described above has a layer structure of "anode/hole injection layer/light-emitting layer/cathode". However, the organic EL element may have an element structure different from the organic EL element of the present embodiment so long as the organic EL element comprises a pair of electrodes and a light-emitting layer between the electrodes. Layers capable of being provided between the anode and the cathode are described below. Among the layers, layers containing organic substances can be formed as organic layers having uniform film thickness by a coating method such as the ink-jet printing method as described above so long as the organic materials forming the layers are dissolvable in solvents. Light-emitting portion provided between the anode and the cathode preferably comprises one or a plurality of organic layers only formed by a coating method. Thus, the light-emitting portion consists of only organic layer(s), and as a result, the light-emitting portion can be formed by a coating method with simple process to facilitate the processing.

Examples of the layer provided between the cathode and the light-emitting layer include an electron injection layer, an electron transport layer, and a hole block layer. When a single layer is provided between the cathode and the light-emitting layer, the layer is called the electron injection layer. When both of the electron injection layer and the electron transport layer are provided between the cathode and the light-emitting layer, the layer making contact with the cathode is called the electron injection layer, and the layer except for the electron injection layer is called the electron transport layer.

The electron injection layer is a layer having function to improve electron injection efficiency from the cathode. The electron transport layer is a layer having function to improve electron injection from the cathode, the electron injection layer, or the electron transport layer closer to the cathode. The hole block layer is a layer having function to block the transport of holes. When any one of the electron injection layer and the electron transport layer or both has function to block the transport of holes, the layer may also serve as the hole block layer.

The function of the hole block layer to block the transport of holes can be confirmed by, for example, manufacturing an element in which only hole current flows and confirming an effect of blocking holes through the reduction of the current value.

Examples of the layers provided between the anode and the light-emitting layer include a hole injection layer, a hole transport layer, and an electron block layer. When both of the hole injection layer and the hole transport layer are provided between the anode and the light-emitting layer, the layer making contact with the anode is called the hole injection layer, and the layer except for the hole injection layer is called the hole transport layer.

The hole injection layer is a layer having function to improve hole injection efficiency from the anode. The hole transport layer is a layer having function to improve hole injection from the anode, the hole injection layer, or the hole transport layer closer to the anode. The electron block layer is a layer having function to block the transport of electrons. When any one of the hole injection layer and the hole transport layer or both has function to block the transport of electrons, the layer may also serve as the electron block layer.

The function of the electron block layer to block the transport of electrons can be confirmed by, for example, manufacturing an element in which only electron current flows and confirming an effect of blocking electrons through the reduction of the current value.

The electron injection layer and the hole injection layer may be collectively called charge injection layers, and the electron transport layer and the hole transport layer may be collectively called charge transport layers.

Examples of Layer structures applicable to the organic EL element of the present embodiment are indicated below.
a) anode/light-emitting layer/cathode
b) anode/hole injection layer/light-emitting layer/cathode
c) anode/hole injection layer/light-emitting layer/electron injection layer/cathode
e) anode/hole injection layer/light-emitting layer/electron transport layer/cathode
f) anode/hole injection layer/light-emitting layer/electron transport layer/electron injection layer/cathode
d) anode/hole transport layer/light-emitting layer/cathode
e) anode/hole transport layer/light-emitting layer/electron injection layer/cathode
f) anode/hole transport layer/light-emitting layer/electron transport layer/cathode
g) anode/hole transport layer/light-emitting layer/electron transport layer/electron injection layer/cathode
h) anode/hole injection layer/hole transport layer/light-emitting layer/cathode
i) anode/hole injection layer/hole transport layer/light-emitting layer/electron injection layer/cathode
j) anode/hole injection layer/hole transport layer/light-emitting layer/electron transport layer/cathode
k) anode/hole injection layer/hole transport layer/light-emitting layer/electron transport layer/electron injection layer/cathode
l) anode/light-emitting layer/electron injection layer/cathode
m) anode/light-emitting layer/electron transport layer/cathode
n) anode/light-emitting layer/electron transport layer/electron injection layer/cathode
(Where a symbol "forward slash (/)" indicates that the layers crossing the symbol "/" are adjacently stacked. The same shall apply hereinafter.)

The organic EL element of the present embodiment may comprise two or more light-emitting layers. The organic EL element having two light-emitting layers may be, among any one of the layer structures of a) to n) described above, a layer structure of o) below where a layered body interposed between an anode and a cathode is indicated by a "repeating unit A".
o) anode/(repeating unit A)/charge injection layer/(repeating unit A)/cathode

The organic EL element having three or more light-emitting layers may be a layer structure of p) below where "(repeating unit A)/charge injection layer" is indicated by a "repeating unit B".
p) anode/(repeating unit B)x/(repeating unit A)/cathode

In this structure, a symbol "x" is an integer of two or more, and (repeating unit B)x is a layered body in which the repeating unit B is layered x times.

The charge injection layer is a layer generating holes and electrons when electric field is applied thereto. Examples of the charge injection layer include a thin film made of vanadium oxide, ITO, molybdenum oxide, or the like.

The organic EL element of the present embodiment may further include an insulating layer having a film thickness of 2 nanometers or less so as to adjacent to an electrode in order to improve adhesion with the electrode and charge injection properties from the electrode. A thin buffer layer may also be inserted between the respective layers described above to improve adhesion at the interface, to prevent mixing, and the like.

The order or the number of the layers to be stacked and the thickness of each of the layers may be appropriately set in consideration of light-emitting efficiency or element life.

The material of and the method for forming each layer constituting the organic EL element are described more specifically below.

### (Hole injection layer)

Hole injection materials constituting the hole injection layer may be an oxide such as vanadium oxide, molybdenum oxide, ruthenium oxide, and aluminum oxide; a phenylamine, a starburst-type amine, a phthalocyanine, amorphous carbon, polyaniline, or a polythiophene derivative.

A method for forming a film of the hole injection layer may be a method for forming a film from a solution containing the hole injection material. A solvent used for forming a film from the solution is not particularly limited so long as the solvent dissolves the hole injection material. The solvent may be: a chlorine solvent such as chloroform, methylene chloride, and dichloroethane; an ether solvent such as tetrahydrofuran; an aromatic hydrocarbon solvent such as toluene and xylene; a ketone solvent such as acetone and methyl ethyl ketone; an ester solvent such as ethyl acetate, butyl acetate, and ethyl cellosolve acetate; or water.

The method for forming a film from the solution may be a coating method such as a spin coating method, a casting method, a micro-gravure coating method, a gravure coating method, a bar coating method, a roll coating method, a wire bar coating method, a dip coating method, a spray coating method, a screen printing method, a flexo printing method, an offset printing method, or an ink-jet printing method.

The optimal value for the film thickness of the hole injection layer varies depending on the material used. The film thickness is appropriately set so as to have moderate values of driving voltage and light-emitting efficiency and needs to be at least a thickness with which no pinhole is formed. When the thickness is too large, the driving voltage of the element increases, which is not preferable. Accordingly, the film thickness of the hole injection layer is, for example, 1 nanometer to 1 micrometer, preferably, 2 nanometers to 500 nanometers, and more preferably, 5 nanometers to 200 nanometers.

### (Hole transport layer)

A hole transport material constituting the hole transport layer may be polyvinyl carbazole or a derivative thereof, polysilane or a derivative thereof, polysiloxane a derivative having an aromatic amine at the side chain or the main chain, a pyrazoline derivative, an arylamine derivative, a stilbene derivative, a triphenyldiamine derivative, polyaniline or a derivative thereof, polythiophene or a derivative thereof, polyarylamine or a derivative thereof, polypyrrole or a derivative thereof, poly(p-phenylenevinylene) or a derivative thereof, and poly(2,5-thienylene vinylene) or a derivatives thereof.

Among them, the hole transport materials may be preferably, a macromolecular hole transport material such as polyvinyl carbazole or a derivative thereof, polysilane or a derivative thereof, a polysiloxane derivative having an aromatic amine compound group at the side chain or the main chain, polyaniline or a derivative thereof, a polythiophene or derivative thereof, polyarylamine or a derivative thereof, poly(p-phenylenevinylene) or a derivative thereof, and poly(2,5-thienylene vinylene) or a derivative thereof, and more preferably, polyvinyl carbazole or a derivative thereof, polysilane or a derivative thereof, and a polysiloxane derivative having an aromatic amine at the side chain or the main chain. When the hole transport material is a low molecular material, the material is preferably used by being dispersed in a macromolecular binder.

A method for forming a film of the hole transport layer is not particularly limited. However, examples of a method for forming a film using a low molecular hole transport material may be a method for forming a film from a mixed solution of a macromolecular binder or the hole transport material, and a method for forming a film using a macromolecular hole transport material may be a method for forming a film from a solution containing the hole transport material.

A solvent used for forming a film from the solution is not particularly limited so long as the solvent dissolves the hole transport material. The solvent may be: a chlorine based solvent such as chloroform, methylene chloride, and dichloroethane; an ether based solvent such as tetrahydrofuran; an aromatic hydrocarbon based solvent such as toluene and xylene; a ketone based solvent such as acetone and methyl ethyl ketone; or an ester based solvent such as ethyl acetate, butyl acetate, and ethyl cellosolve acetate.

The method for forming a film from the solution may be a coating method similar to the method for forming a film of the hole injection layer described above.

For the macromolecular binder to be mixed, a binder that does not extremely inhibit charge transportation is preferable, and a binder that has weak absorption of visible light is suitably used. Examples of the macromolecular binder may include polycarbonate, polyacrylate, polymethyl acrylate, polymethyl methacrylate, polystyrene, polyvinyl chloride, and polysiloxane.

The optimal value for the film thickness of the hole transport layer varies depending on the material used. The film thickness is appropriately set so as to have moderate values of driving voltage and light-emitting efficiency and needs to be at least a thickness with which no pinhole is formed. When the thickness is too large, the driving voltage of the element increases, which is not preferable. Accordingly, the film thickness of the hole transport layer is, for example, 1 nanometer to 1 micrometer, preferably, 2 nanometers to 500 nanometers, and more preferably, 5 nanometers to 200 nanometers.

### (Light-emitting layer)

The light-emitting layer is generally made of an organic substance that mainly emits any one of fluorescence and phosphorescence or both, or made of the organic substance and a dopant assisting the organic substance. The dopant is added in order to, for example, improve the light-emitting efficiency and change the emission wavelength. The organic substance may be a low molecular compound or a macromolecular compound. The light-emitting layer preferably includes a macromolecular compound having a number average molecular weight of 10³ to 10⁸ in terms of polystyrene. Examples of light-emitting materials constituting the light-emitting layer include the following pigment materials, metal complex materials, macromolecular materials, and dopant materials.

### (Pigment materials)

Examples of the pigment materials may include cyclopendamine derivatives, tetraphenyl butadiene derivative compounds, triphenyl amine derivatives, oxadiazole derivatives, pyrazoloquinoline derivatives, distyrylbenzene derivatives, distyrylarylene derivatives, pyrrole derivatives, thiophene ring compounds, pyridine ring compounds, perynone derivatives, perylene derivatives, oligothiophene derivatives, trifumanyl amine derivatives, oxadiazole dimmers, pyrazoline dimmers, quinacridone derivatives, and coumarin derivatives.

### (Metal complex materials)

Examples of the metal complex materials may include metal complexes having as a central metal, Al, Zn, Be, a rare-earth metal such as Tb, Eu, and Dy, or the like and having as a ligand, a structure of oxadiazole, thiadiazole, phenylpyridine, phenylbenzimidazole, quinoline, or the like, for example, metal complexes such as iridium complexes and platinum complexes that emit light from the triplet excited state, alumiquinolinol complexes, benzoquinolinole beryllium complexes, benzoxazolyl zinc complexes, benzothiazole zinc complexes, azomethyl zinc complexes, porphyrin zinc complexes, and europium complexes.

### (Macromolecular materials)

The macromolecular materials may be a polyparaphenylene vinylene derivative, a polythiophene derivative, a polyparaphenylene derivative, a polysilane derivative, a polyacetylene derivative, a polyfluorene derivative, a polyvinyl carbazole derivative, and a material obtained by polymerizing the pigment materials or the metal complex light-emitting material.

Among the light-emitting materials described above, the material that emits blue light may be a distyrylarylene derivative, an oxadiazole derivative, and a polymer of a distyrylarylene derivative and an oxadiazole derivative, a polyvinyl carbazole derivative, a polyparaphenylene derivative, or a polyfluorene derivative. Among them, polymer materials such as polyvinyl carbazole derivatives, polyparaphenylene derivatives, and polyfluorene derivatives are preferred.

The material that emits green light may be a quinacridone derivative, a coumarin derivative, a polymer of a quinacridone derivative and a coumarin derivative, a polyparaphenylene vinylene derivative, or a polyfluorene derivatives. Among them, polymer materials such as polyparaphenylene vinylene derivatives and polyfluorene derivatives are preferred.

The material that emits red light may be coumarin derivatives, thiophene ring compounds, polymers thereof, polyparaphenylene vinylene derivatives, polythiophene derivatives, and polyfluorene derivatives. Among them, polymer materials such as polyparaphenylene vinylene derivatives, polythiophene derivatives, and polyfluorene derivatives are preferred.

### (Dopant materials)

Examples of the dopant materials may include perylene derivatives, coumarin derivatives, rubrene derivatives, quinacridone derivatives, squarylium derivatives, porphyrin derivatives, styryl pigments, tetracene derivatives, pyrazolone derivatives, decacyclene, and phenoxazon. The thickness of the light-emitting layer is generally about 2 nanometers to 200 nanometers.

### (Electron transport layer)

Publicly known materials may be used for electron transport materials constituting the electron transport layer. The material may be an oxadiazole derivative, anthraquinodimethane or a derivative thereof, benzoquinone or a derivative thereof, naphthoquinone or a derivative thereof, anthraquinone or a derivative thereof, tetracyanoanthraquinodimethane or a derivative thereof, a fluorenone derivative, diphenyldicyanoethylene or a derivative thereof, a diphenoquinone derivative, a metal complexe of 8-hydroxyquinoline or of a derivative of 8-hydroxyquinoline, polyquinoline or a derivative thereof, polyquinoxaline or a derivative thereof, and polyfluorene or a derivative thereof.

Among them, as the electron transport materials, preferred are oxadiazole derivatives, benzoquinone or derivatives thereof, anthraquinone or derivatives thereof, metal complexes of 8-hydroxyquinoline or of derivatives of 8-hydroxyquinoline, polyquinoline or derivatives thereof, polyquinoxaline or derivatives thereof, and polyfluorene or derivatives thereof, and more preferred are 2-(4-biphenylyl)-5-(4-t-butylphenyl)-1,3,4-oxadiazole, benzoquinone, anthraquinone, tris(8-quinolinol)aluminum, and polyquinoline.

A method for forming a film of the electron transport layer is not particularly limited. However, a method for forming a film using a low molecular electron transport material may be a vacuum deposition method using the powder, or a method for forming a film from the solution or from the melted state, and a method for forming a film using a macromolecular electron transport material may be a method for forming a film from the solution or from the melted state. When a film is formed from the solution or from the melted state, a macromolecular binder may also be used in combination. A method for forming a film of the electron transport layer from the solution may be a film forming method similar to the method for forming a film of the hole transport layer from the solution as described above.

The optimal value for the film thickness of the electron transport layer varies depending on the material used. The film thickness is set as appropriate so as to have moderate values of driving voltage and light-emitting efficiency and needs to be at least a thickness with which no pinhole is formed. When the thickness is too large, the driving voltage of the element increases, which is not preferable. Accordingly, the film thickness of the electron transport layer is, for example, 1 nanometer to 1 micrometer, preferably, 2 nanometers to 500 nanometers, and more preferably, 5 nanometers to 200 nanometers.

### (Electron injection layer)

For materials constituting the electron injection layer, optimal materials are appropriately selected depending on the type of the light-emitting layer. The material may be: an alkali metal; an alkaline-earth metal; an alloy that contains one or more types of alkali metals and an alkaline-earth metal; an oxide, a halide, and a carbonate of an alkali metal or an alkaline-earth metal; or a mixture of these substances. Examples of the alkali metals, or the oxides, halides, and carbonates of alkali metals may include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. Examples of the alkaline-earth metals or the oxides, halides, and carbonates of alkaline-earth metals may include magnesium, calcium, barium, strontium, magnesium oxide, magnesium fluoride, calcium oxide, calcium fluoride, barium oxide, barium fluoride, strontium oxide, strontium fluoride, and magnesium carbonate. The electron injection layer may also be a layered body in which two or more layers are stacked, and examples thereof include LiF/Ca. The electron injection layer is formed by a vapor deposition method, a sputtering method, a printing method, or the like.

The film thickness of the electron injection layer is preferably about 1 nanometer to 1 micrometer.

### (Insulating layer)

A material for the insulating layer may be a metal fluoride, a metal oxide, and an organic insulating material. The organic EL element that includes the insulating layer having a film thickness of 2 nanometers or less may be: an organic EL element including the insulating layer having a film thickness of 2 nanometers or less that is adjacent to the cathode; or an organic EL element including the insulating layer having a film thickness of 2 nanometers or less that is adjacent to the anode.

The light-emitting device described above can be suitably used for curved or flat illumination devices, planar light sources used for, for example, light sources of scanners, and display devices.

The display devices may be a segment display device, a dot-matrix display device or the like. The dot-matrix display device may be an active matrix display device, a passive matrix display device, or the like. In the active matrix display devices and the passive matrix display devices, the organic EL element is used as a light-emitting element constituting each pixel. The organic EL element is used as a light-emitting element constituting each segment in the segment display devices and is used as a backlight in liquid crystal display devices.

### INDUSTRIAL APPLICABILITY

According to the present invention, the influence exerted by the insulating film during the formation of the light-emitting portion can be reduced by forming the insulating film thinner than the light-emitting portion, and as a result, organic layers having uniform film thickness can be formed in the pixel area. Accordingly, an organic electroluminescent element in which light emission failure is suppressed can be obtained, and thus, a light-emitting device with high performance can be realized.

## Claims

1. A light-emitting device comprising:
a substrate;
a plurality of organic electroluminescent elements provided on the substrate; and
a partition defining pixel areas in each of which one of the organic electroluminescent elements is provided, wherein
the partition comprises an insulating film provided with openings each hollowly formed in an area corresponding to one of the pixel areas and a partition body provided on an opposite side of the insulating film with respect to the substrate,
each of the organic electroluminescent elements comprises a pair of electrodes and a light-emitting portion that is interposed between the electrodes and that is arranged in an area surrounded by the partition, and
the thickness of the insulating film is smaller than the thickness of the light-emitting portion.

2. The light-emitting device according to claim 1, wherein the thickness of the insulating film is less than 50 nanometers.

3. The light-emitting device according to claim 1 or 2, wherein an opening defined by a side face of the insulating film facing each of the openings has a shape that is forward-tapered in a direction directing to the substrate.

4. The light-emitting device according to any one of claims 1 to 3, wherein when viewed from one side of the thickness direction of the substrate, the distance between a side face of the insulating film facing the pixel areas and a side face of the partition body facing the pixel areas is 1 micrometer or more.

5. The light-emitting device according to any one of claims 1 to 4, wherein the light-emitting portion comprises an organic layer formed by a coating method using an ink containing an organic material.

6. The light-emitting device according to any one of claims 1 to 5, wherein the insulating film exhibits lyophilicity to the ink more than the partition body does.

7. The light-emitting device according to any one of claims 1 to 6, wherein the light-emitting portion is formed by stacking a plurality of layers comprising a hole injection layer provided closest to the substrate.

8. A method for manufacturing a light-emitting device comprising a plurality of organic electroluminescent elements each comprising a pair of electrodes and a light-emitting portion interposed between the pair of electrodes, the method comprising:
a step of forming, on a substrate, a partition defining pixel areas in each of which one of the organic electroluminescent elements is provided;
a step of forming the electrodes; and
a step of forming the light-emitting portion in each of the pixel areas, wherein
in the step of forming the partition, an insulating film is formed that has a thickness smaller than the thickness of the light-emitting portion and that is provided with openings each hollowly formed in an area corresponding to one of the pixel areas, and a partition body is formed on the insulating film, and
in the step of forming the light-emitting portion, an ink containing an organic material is supplied into the pixel areas, and the ink thus supplied is dried to form an organic layer.

9. The method for manufacturing a light-emitting device according to claim 8, wherein in hollowly forming the openings in the insulating film, openings each having a shape that is forward-tapered in a direction directing to the substrate are hollowly formed in the insulating film by dry etching.

10. The method for manufacturing a light-emitting device according to claim 8 or 9, wherein in forming the partition body, the partition body is formed using an organic substance and then a plasma treatment performed in a fluorine-containing gas atmosphere.
